# EUROPÄISCHE PATENTSCHRIFT

(11) **EP 1 685 594 B1**
(45) Veröffentlichungstag und Bekanntmachung des Hinweises auf die Patenterteilung: **03.10.2012**
(21) Anmeldenummer: 04818378.4
(22) Anmeldetag: 08.11.2004
(51) Int. Cl.: H01L 23/051, H01L 23/049

(54) **EINPRESSDIODE**
PRESS-FIT DIODE
DIODE EMBROCHABLE

(30) Priorität: 10.11.2003 DE 10352852
(43) Veröffentlichungstag der Anmeldung: 02.08.2006
(73) Patentinhaber: ROBERT BOSCH GMBH, 70442 Stuttgart (DE)
(72) Erfinder: SPITZ, Richard, 72766 Reutlingen (DE); HAMSEN, Karin, 72070 Tübingen (DE); DIETRICH, Jochen, 89079 Ulm (DE)
(86) Internationale Anmeldenummer: PCT/DE2004/002463
(87) Internationale Veröffentlichungsnummer: WO 2005/048344

(56) Entgegenhaltungen:
- DE-A1- 3 011 491
- DE-A1- 4 112 286
- FR-A- 2 454 699
- US-A- 6 160 309
- US-A1- 2002 145 189

## Beschreibung

Die Erfindung betrifft eine Diode, insbesondere eine Hochleistungs-Einpressdiode für einen Gleichrichter in einem Kraftfahrzeug.

### Stand der Technik

Es ist üblich, dass zur Gleichrichtung von Wechselströmen Dioden eingesetzt werden, dies gilt auch für Gleichrichter in Kraftfahrzeugen, bei denen zur Gleichrichtung der von einem Drehstromgenerator gelieferten Ausgangsströme eine Gleichrichterbrücke mit insgesamt sechs Leistungsdioden eingesetzt wird. Diese Leistungsdioden sind beispielsweise sogenannte Einpressdioden, dabei handelt es sich um Dioden, die in eine Halterung eingepresst werden und damit mit dieser verbunden werden.

Einpressdioden für Kraftfahrzeuggleichrichter werden beispielsweise in den Druckschriften DE-OS 43 41 269 und DE-P 195 49 202 beschrieben. Dabei werden die grundsätzlichen Konstruktionsmerkmale von mit Kunststoff ummantelten Einspressdioden beschrieben. Diese Einspressdioden umfassen einen Chip, der mittels Lötschichten mit einem Kopfdraht und einem Sockel verbunden ist. Kopfdraht und Sockel sind mit einem Kunststoffmantel sind von einem Kunststoffmantel umgeben, der eine mechanische Verbindung herstellt. Der Sockel umfasst einen Einpressbereich, der sich bei Einpressen der Diode in den Gleichrichter leicht verformt.

In Figur 1 ist ein Beispiel einer aus der DE P-195 49 202 bekannten mit Kunststoff ummantelten Diode dargestellt. Die Diode besteht dabei im Wesentlichen aus einem Sockel 1, einer Hülse 2 sowie einem Chip 3, der zwischen dem Sockel 1 und dem Kopfdraht 4 liegt. Der Chip 3 ist dabei mittels Lot 5a, 5b sowohl mit dem Sockel 1 als auch mit dem Kopfdraht 4 fest verbunden. Teile der Diode können mit Lack 6 überzogen sein. Eine Kunststoffummantelung 7 gibt den mechanischen Halt und stellt also eine feste mechanische Verbindung zwischen dem Sockel 1 und dem Kopfdraht 4 her.

Der vorstehend beschriebene prinzipielle Aufbau einer Diode, beispielsweise einer Leistungsdiode, die in einen Gleichrichter für einen Drehstromgenerator in einem Kraftfahrzeug eingepresst wird, unterscheidet sich noch nicht wesentlich von anderen bekannten Dioden, insbesondere Einpressdioden. Die bekannten Dioden mit diesem Aufbau benötigen jedoch eine Bauhöhe von mindestens 8 mm. Die erfindungsgemäße im Folgenden beschriebene Ausgestaltung erlaubt eine flachere Bauweise und ermöglicht den Einsatz der Diode bei Generatorkonstruktionen, bei denen für Bauhöhen von mehr als 8 mm nicht mehr genügend Raum vorhanden ist.

Es sind aber auch bereits andere flache Leistungsdioden bekannt, die nur eine Bauhöhe von 4 mm aufweisen. Diese flachen Diode weisen dann ein topfartig gestaltetes Gehäuse auf, das die geringe Bauhöhe ermöglicht. Beim Einpressen solcher bekannter Topfdioden in das Gleichrichterblech wird der Rand des Gehäuses zwangsläufig durch die Pressfassung zwischen Diode und Einpressblock nach innen verformt und drückt auf die den Chip schützende Kunststoffummantelung,.

Um diese Verformung aufnehmen bzw. abzufangen zu können, ist die Kunststoffummantelung bei einer solchen bekannten Topfdiode aus einem elastischen gummiartigen Weichverguss, beispielsweise gefülltem Silikon. Daraus ergibt sich der Nachteil, dass etwaige Zugbelastungen sich direkt auf das Lot, mit dem der Chip mit dem Sockel und dem Kopfdraht verbunden ist, bzw. auf den Chip selbst auswirken. Zur Lösung dieses Problems kann eine Zugentlastung im Kopfdraht vorgesehen werden, welche die Handhabung bei der Verarbeitung schwierig macht und zusätzliche Arbeitsgänge erfordert. Mit der elastischen Ummantelung ist zudem ohne zusätzliche Maßnahmen keine sichere Verklammerung von Diodensockel und Diodenkopfdraht gegeben, so dass Lot und Chip bei Temperaturwechseln nicht durch die Ummantelung entlastet werden. Dies kann gegebenenfalls zu einer verringerten Lebensdauer der Diode führen.

Aus der Entgegenhaltung DE-OS 3 11 491 ist eine Einpressdiode mit einem Chip, der über Lotschichten mit einem Kopfdraht und einem Sockel verbunden ist, bekannt, mit einer Kunststoffummantelung, die eine Hülse umfasst und wenigstens im Bereich des Chips vorhanden ist und eine mechanische Verbindung bildet. Der Sockel wird von der Kunststoffummantelung zumindest teilweise umschlossen, wodurch ein Gehäuse gebildet wird. Eine Hinterschneidung ragt in die in die Kunststoffummantelung und fixiert so das Gehäuse auf dem Sockel.

Die Entgegenhaltung US 2002/0145189 A1 zeigt eine weitere Einpressdiode, die in einen Gleichrichter eingepresst werden kann.

### Vorteile der Erfindung

Die erfindungsgemäße Diode mit den Merkmalen des Hauptanspruchs hat den Vorteil, dass nur eine sehr kleine Bauhöhe benötigt wird, dass eine besonders einfache Einpressung in den Gleichrichter möglich ist und dass eine längere Lebensdauer bei Temperaturwechseln sowie eine höhere mechanische Robustheit gewährleistet ist. Erzielt werden diese Vorteile, indem die Diode so ausgestaltet wird, dass zusätzlich zu bekannten Komponenten wenigstens ein Spalt vorgesehen wird, der beim Einpressen eine Verformung erlaubt und entstehende mechanische Kräfte verringert bzw. verhindert. Besonders vorteilhaft ist, dass die Diode beidseitig einpressbar ist und über einen sogenannten Hartverguss verfügt.

Weitere Vorteile der Erfindung werden durch die in den Unteransprüchen angegebenen Maßnahmen erzielt. Von Vorteil ist dabei, dass die Diode, insbesondere Einpressdiode, einen Chip umfasst, der über Lotschichten mit einem ersten Teil, einem sogenannten Kopfdraht und einen zweiten Teil, einen sogenannten Sockel, verbunden ist und mit einer Kunststoffummantelung umgeben ist, die wenigstens im Bereich des Chips vorhanden ist und eine mechanische Verbindung bildet. Das zweite Teil, also der Sockel, bildet einen Teil eines Gehäuses, was die Kunststoffummantelung zumindest teilweise umschließt, wobei zur Fixierung wenigstens eine Hinterschneidung vorhanden ist. Das Gehäuse bzw. der Sockel ist in vorteilhafter Weise aus einem guten elektrischen und/oder gut wärmeleitenden Material. Die Höhe des Sockels wird in vorteilhafter Weise so gewählt, dass eine ausreichende Verklammerung von Sockel und Kopfdraht erhalten wird und beträgt in vorteilhafter Weise mindestens 0,5 bis 0,8 mm.

Das Gehäuse kann Phasen- bzw. Einführschrägen im Pressbereich aufweisen, die ein beidseitiges Einpressen der Dioden in einen Gleichrichter ermöglichen. Die Kunststoffummantelung zwischen dem Gehäuse und dem Chip besteht in vorteilhafter Ausgestaltung aus wenigstens einer Hülse und einem mit Vergussmasse ausgefüllten Teilbereich. Das Gehäuse bildet einen Topfrand, mit einem ersten Innendurchmesser und einem Bereich mit verringertem Innendurchmesser.

Der Spalt kann in vorteilhafter Weise an Erfordernisse angepasst werden, dies gilt sowohl für seine Breite, Tiefe und Form, wobei eine vorteilhafte Ausgestaltung einen Spalt mit annähernd gleicher Breite hat und eine weitere vorteilhafte Lösung einen v-förmigen Spalt aufweist mit sich zum Sockelboden verringernden Breite.

### Zeichnung

Ausführungsbeispiele der Erfindung sind in der Zeichnung dargestellt und werden in der nachfolgenden Beschreibung näher erläutert. Im Einzelnen zeigt Figur 1 eine bekannte Diode, Figur 2 eine Gesamtansicht einer erfindungsgemäßen Diode und Figur 3 Einzelheiten zum Diodensockel, einem sogenannten M-Sockel. In Figur 4 ist schematisch ein Gleichrichter mit den Löchern für die einzupressenden Dioden dargestellt. Und in den Figuren 5 und 6a bis 6c sind weitere Beispiele für die Ausgestaltung von erfindungsgemäßen Dioden dargestellt. In Figur 7 sind konstruktive Einzelheiten für den Sockel eines weiteren Ausführungsbeispiels dargestellt und Figur 8a bis 8f zeigt weitere konstruktive Ausgestaltungen von erfindungsgemäßen Dioden.

### Beschreibung

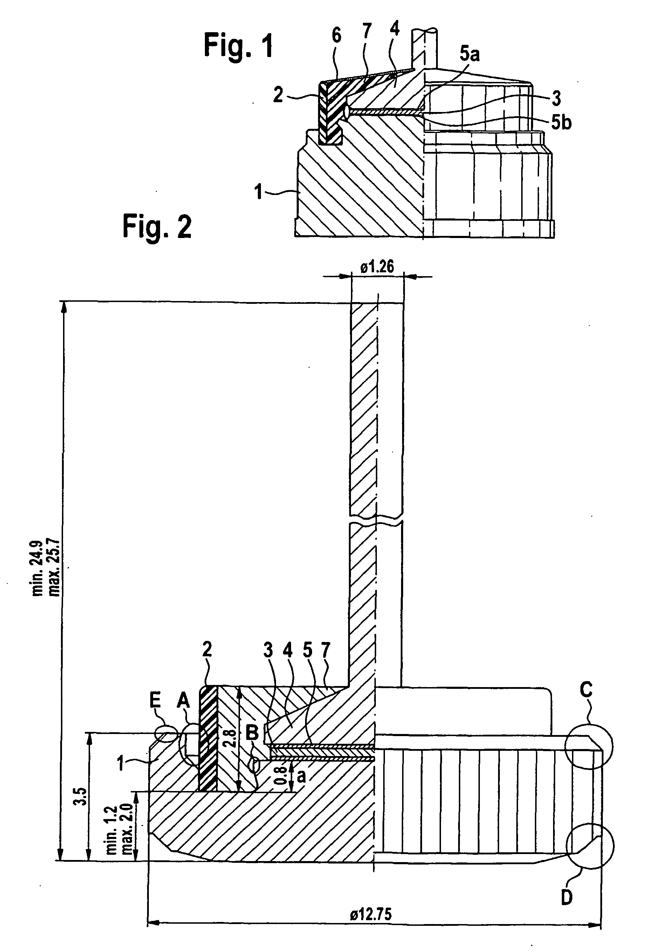

Bei erfindungsgemäßen Dioden wird der in Figur 1 für eine bekannte Diode dargestellte prinzipielle Aufbau verändert bzw. optimiert. In Figur 2 ist ein Ausführungsbeispiel einer erfindungsgemäßen, vorzugsweise mit Kunststoff ummantelten Diode dargestellt. Die Diode besteht dabei ebenfalls aus einem Sockel 1, einer Hülse 2 sowie einem Chip 3, der zwischen dem Sockel 1 und dem Kopfdraht 4 liegt. Im Bereich des Chips 3 weist der Sockel 1 ein insbesondere rotationssymmetrisches Podest 8 auf , das sich um eine Höhe a gegenüber einem Graben 9 erhebt. Der Rand 10 befindet sich rotationssymmetrisch im äußeren Bereich des Sockels 1. Der Chip 3 ist mittels Lot 5a, 5b sowohl mit dem Sockel 1 als auch mit dem Kopfdraht 4 fest verbunden. Teile der Diode, beispielsweise die Außenseite des Chips 3 können mit Lack 6 überzogen sein, wobei der Lacküberzug eine optionale Möglichkeit darstellt. Eine Kunststoffummantelung 7 gibt den mechanischen Halt und stellt also eine feste mechanische Verbindung zwischen dem Sockel 1 und dem Kopfdraht 4 her.

Bei dem in Figur 2 dargestellten Ausführungsbeispiel für eine erfindungsgemäße Diode werden wenigstens eine oder mehrere der Komponenten Sockel 1, Hülse 2, Chip 3, Kopfdraht 4, Lot 5, Lack 6 und/oder Kunststoffummantelung 7 gegenüber der in Figur 1 dargestellten bekannten Lösung abgewandelt bzw. spezifiziert, so dass die erfindungsgemäß angegebenen Vorteile entstehen. Der Sockel 1, die Hülse 2 und die Kunststoffummantelung 7 bilden ein Gehäuse, das so genannte M-Gehäuse.

Der Sockel 1 wird aus Gründen der guten elektrischen Leitfähigkeit bei gleichzeitig guter Wärmeleitfähigkeit aus hochreinem Kupfer hergestellt. Bei der Herstellung des Sockels wird auch eine Hinterschneidung B angebracht, die eine sichere Fixierung gewährleisten soll. Die Hinterschneidung B ist dabei im Bereich des Podests 8 angebracht und kann beispielsweise als umlaufender Kragen ausgestaltet sein. Dabei ist die Bemassung so zu wählen, dass das Maß der Höhe a ausreichend groß gewählt wird, um für die Verklammerung von Sockel 1 und Kopfdraht 4 durch die Kunststoffummantelung 7 genügend Raum zu bieten. Beim Ausführungsbeispiel beträgt dieser Raum 0,8 mm, mindestens erforderlich sind jedoch 0,5 mm. Ein kleineres Maß kann sich gegebenenfalls verkürzend auf die Lebensdauer bei Temperaturwechselbelastung auswirken.

Im oberen Bereich des Sockels vergrößert sich auf Grund der Hinterschneidung B der Innendurchmesser des "Topfrandes" bzw. des Podestes 8 und schafft so im zusammengebauten Zustand einen Abstand zwischen montierter Hülse 2 und Sockelrand. Die Oberkante und die Unterkante weisen Fasen bzw. Einführschrägen C und D auf, die ein besseres Einführen beim Zusammenbau ermöglichen. Zur Sicherstellung der Lötbarkeit wird auf die Oberfläche des Kupfers des Sockels 1 stromlos eine Nickelschicht aufgebracht.

Die Hülse 2 ist beispielsweise zylinderförmig ausgestaltet und besteht aus einem Polyester, beispielsweise aus PET oder PBT und dient als Form für die Kunststoffummantelung, die beispielsweise aus quarzgefülltem Epoxid besteht. Die Hülse 2 dichtet dabei den unteren Bereich der Diode ab und ist im Wesentlichen gleich aufgebaut wie bei bekannten Dioden gemäß Figur 1. Die Hülse wird bei der Herstellung der Diode nach dem Zusammenbau und Verlötung von Sockel und Diodenkopf eingepresst. Dabei hat die die zylinderförmige Hülse 2 bei diesem Ausführungsbeispiel einen etwas größeren Außendurchmesser als der Topfbereich des Sockels 1.

Der Chip 3 ist ein Halbleiterchip, der entsprechend den elektrischen Anforderungen wenigstens einen pn-Übergang aufweist und so eine Diodenfunktion realisiert. Es kann auch eine Zenerdiodenfunktion, eine Transistorfunktion oder eine andere, in der Halbleitertechnik bekannte Funktion realisiert sein.

Der Kopfdraht 4 entspricht in seiner Form und Funktion dem Kopfdraht einer bekannten Einpressdiode, beispielsweise der aus der DE- 195 49 202 bekannten Einpressdiode nach Figur 1. Die Größe, insbesondere der Durchmesser, wird an die Chipgröße bzw. Chipauflagefläche des Sockels angepasst. Es gilt, dass der Durchmesser des Kopfdrahttellers kleiner ist als der Durchmesser der Chipauflage des Sockels. Material und Oberfläche sind identisch mit dem Material des Sockels 1, das Material ist also insbesondere Kupfer, das gegebenenfalls noch mit Nickel beschichtet ist.

Als Lot 5a, 5b wird ein üblicherweise bei der Herstellung von Einpressdioden bzw. Leistungsdioden für Fahrzeuggleichrichter eingesetztes Lot verwendet.

Der Lack 6, der im äußeren Bereich des Chips aufgebracht wird, aber nicht zwingend erforderlich ist, weist eine in der Halbleitertechnik übliche Zusammensetzung auf.

Die Kunststoffummantelung 7 ist als Hartverguss realisiert und besteht aus einem quarzgefüllten Epoxid.

Im Gegensatz zu den bekannten Topfdioden, bei denen ein Hartverguss nicht möglich ist, kann bei der Diode nach Figur 2 ein solcher Hartverguss vorgesehen werden. Bei Topfdioden bilden sich beim Einpressen in den Gleichrichter durch die Verformung des Randes und die daraus resultierende Kraft auf den Verguss Risse, die zu einer Undichtheit der Ummantelung führen. Eine solche Rissbildung wird durch das Einfügen einer Kunststoffhülse 2 als Form für den Hartverguss vermieden. Der zwischen der Kunststoffhülse 2 und dem Podest 8 des Sockels 1 entstehende Abstand bzw. Spalt A der Tiefe t und der Breite b verhindert das Entstehen einer schädlichen Kraft auf den Hartverguss in Folge der Verformung des Kupferrandes während des Einpressvorgangs Der Spalt A muss dazu mindestens so breit sein wie die Differenz zwischen den Durchmessern D1 von Einpressloch im Gleichrichter 11 und Durchmesser D2 der Diode. Der Spalt A führt dazu, dass der Sockel 1 einen Rand 10 bildet, mit einem ersten Innendurchmesser und einem Bereich mit verringertem Innendurchmesser.

Zum beidseitigen Einpressen der Diode sind sowohl oben als auch unten die Fasen bzw. Einführschrägen C und D vorgesehen. Die Diode kann so mit einem nicht dargestellten ringförmigen Stempel entweder von unten oder von oben in den Gleichrichter 11 eingepresst werden. Beim Einpressen von oben dient die ringförmige Fläche E als Kontaktfläche für den Einpressstempel.

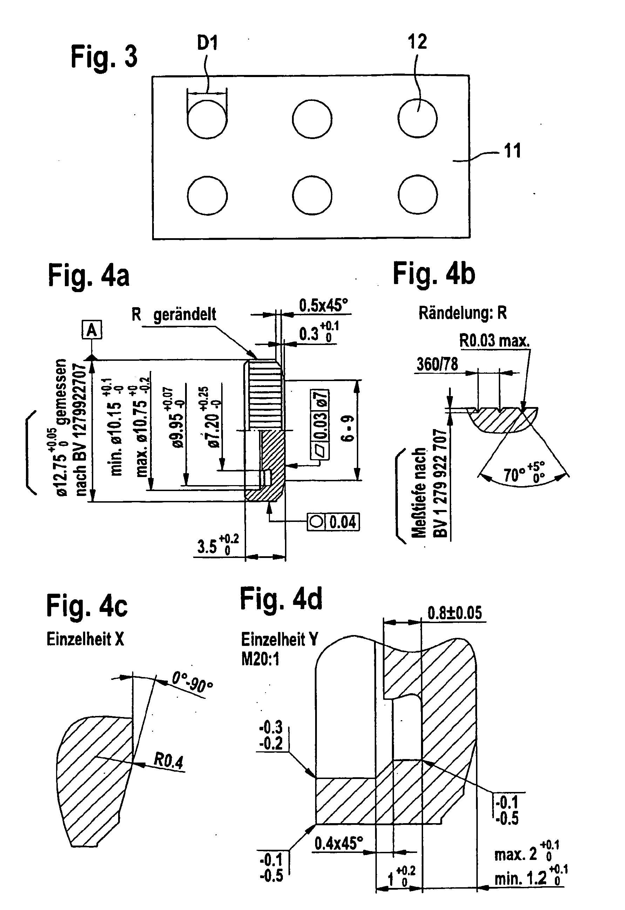

In Figur 3 ist der Gleichrichter 11 schematisch dargestellt, er weist sechs Einpresslöcher 12 auf, mit jeweils einem Durchmesser von D1 in die die Dioden eingepresst werden sollen. Die sechs Dioden bilden nach geeigneter elektrischer Verschaltung dann den Gleichrichter.

Weitere Einzelheiten zur Ausgestaltung des Diodensockels des Ausführungsbeispiels nach Figur 2 zeigen die Figuren 4a bis 4d. In Figur 4a ist der gesamte Sockel dargestellt mit Hinweis auf die Einzelheiten X, Y und die Rändelung R, die zum besseren Einpressverhalten dient. Die Einzelheit X zeigt eine der Fasen (Figur 4c), die Einzelheit Y den Bereich mit dem Schlitz.

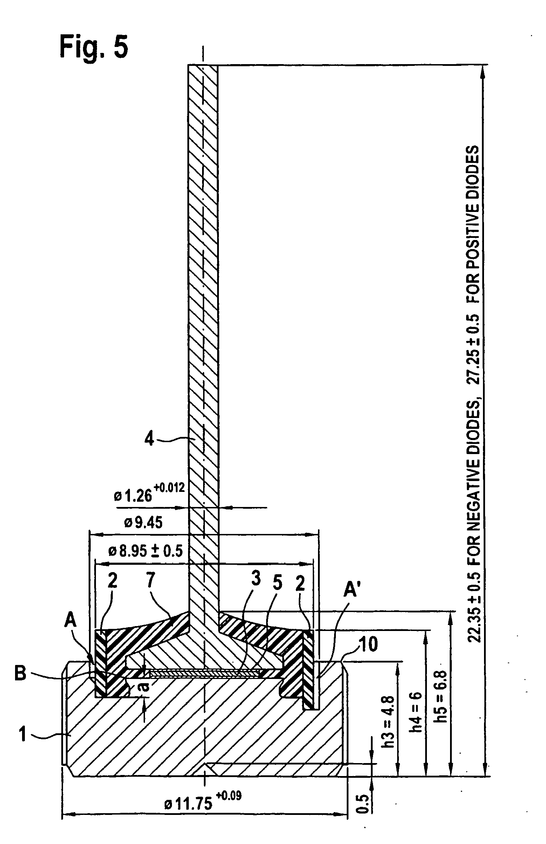

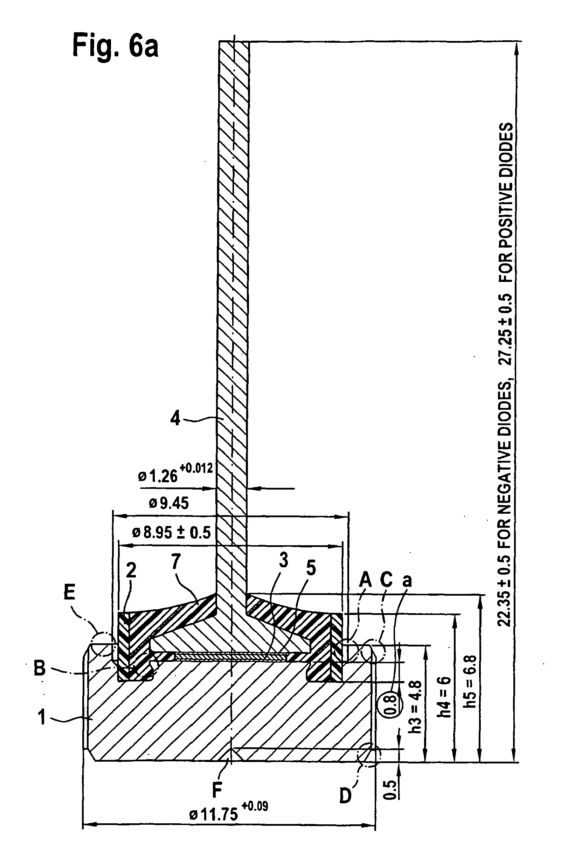

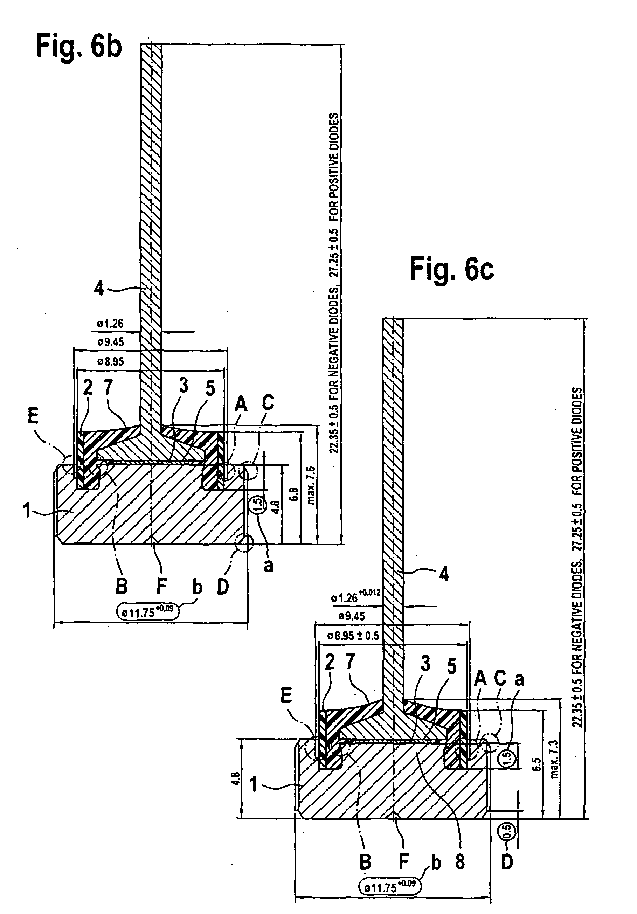

Die Figuren 5 und 6 zeigen weitere Ausführungsbeispiele von erfindungsgemäßen Dioden. Die einzelnen Komponenten tragen die selben Bezugszeichen wie das Ausführungsbeispiel nach Figur 2.

In einer in Figur 5 auf der rechten Seite dargestellten Ausgestaltung wird die Hülse an ihrem Innendurchmesser geklemmt und die gesamte Außenfläche der Hülse berührungsfrei gehalten. Dazu wird der Graben A' so tief gemacht, dass keine Berührung zwischen der Hülse 2 und dem Außen- bzw. Randbereich 10 des Sockels 1 erfolgt. Damit wird die Kraftübertragung beim Einpressen verhindert. Die Hülse kann auch geklebt werden und gegebenenfalls eine zusätzliche Nut aufweisen.

Das Ausführungsbeispiel nach Figur 6a bis 6c weisen zusätzlich eine Kerbe F auf, die vorteilhaft bei der Herstellung der Dioden ist und beispielsweise eine sichere Fixierung bei der Herstellung ermöglicht. Im übrigen unterscheiden sich diese Ausführungsbeispiele nur durch konstruktive Details, insbesondere in der Bemassung, die im Einzelnen den Zeichnungen zu entnehmen sind..

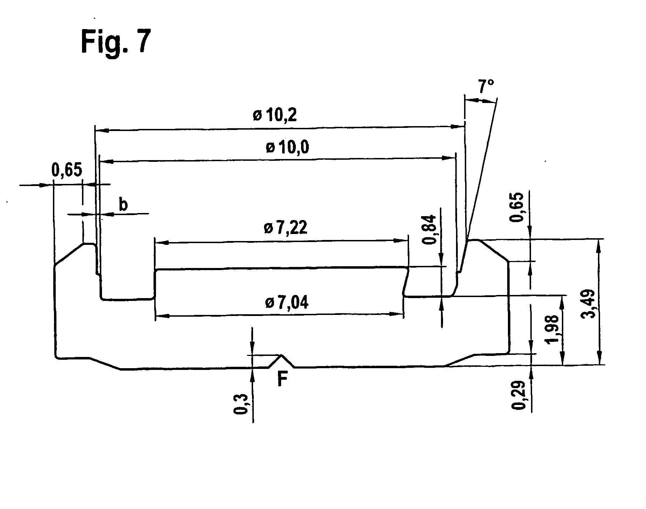

In Figur 7 ist eine weitere Möglichkeit der Bemassung für einen Diodensockel dargestellt.

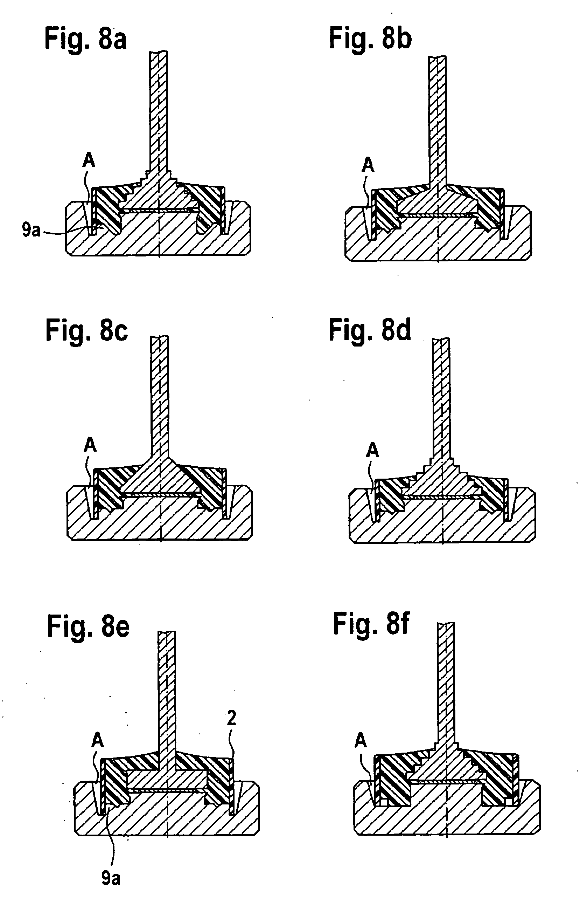

Figur 8a bis 8f zeigt sechs weitere Ausführungsformen der Erfindung. Dabei ist der Spalt A jeweils v-förmig ausgestaltet, also mit zum Diodensockel hin abnehmender Breite b.

Der Diodenkopf bzw.der Kopfdraht 4 kann glatt oder gestuft, mit beispielsweise 2 bis 6 Stufen ausgestaltet sein. Der Winkel der Abschrägung des Kopfdrahtes beträgt beispielsweise 20° oder 50° oder dazwischen liegen oder einen höheren oder kleineren Wert aufweisen, wobei eine Anpassung an Erfordernisse möglich ist.

Der Graben 9 weist je nach Ausführungsform eine glatte Oberfläche auf oder ist strukturiert und hat beispielsweise ein kerbenförmige Vertiefung. Zur Fixierung der Hülse 2 ist eine unterschiedlich ausgestaltete Erhöhung 9a vorgesehen. Die Verstemmung der Hülse 2 kann bei der Herstellung der Diode bei diesen Ausführungsbeispielen so erfolgen, dass der Innendurchmesser der Hülse 2 etwas kleiner gewählt wird als der Außendurchmesser der Erhöhung 9a. Beim Einpressen bzw. Aufstecken der zylinderförmigen Hülse 2 ergibt sich dann eine Fixierung der Hülse.

Der Graben A in Ausgestaltung mit gleichem Durchmesser b oder in v-förmiger Ausgestaltung wird erhalten, indem bei der Herstellung der Diode der innere Randbereich 10 des Sockels 1 entsprechend ausgeformt hergestellt wird. Da der Graben beim gewisse Verformungen zulässt, kann auch bei einer Hartvergussdiode kein Problem mit Rissbildungen beim Einpressen auftreten. Solche Dioden können im Übrigen von beiden Seiten her in einen Gleichrichter eingepresst werden.

Die in den Figuren und der Beschreibung angegebenen Maße sind zweckmäßige Maße, die in gewissen Bereichen variiert werden können. Insbesondere die Angaben max. bzw. min. geben Grenzen für mögliche Wertebereiche an. Auch Verhältnisse bestimmter Größen, beispielsweise das Verhältnis von Grabentiefe t oder Podesthöhe a zu der Höhe h1 oder h2 sollte innerhalb bestimmter Wertebereiche, die durch die in den Figuren angegebenen Werte bzw. Wertebereiche festgelegt werden.

## Patentansprüche

1. Einpressdiode mit einem Chip (3), der über Lotschichten (5a, 5b) mit einem Kopfdraht (4) und einem Sockel (1) verbunder ist, wobei der Sockel (1) im Bereich des Chips (3) ein Podest (8) aufweist, das von einem Graben (9) umgeben ist und sich das Podest (8) um eine Höhe (a) gegenüber dem Graben (9) erhebt, mit einer Kunststoffummantelung (7), die eine Hülse (2) umfasst und wenigstens im Bereich des Chips (3) vorhanden ist und eine mechanische Verbindung bildet, wobei der Sockel (1) die Kunststoffummantelung (7) zumindest teilweise umschließt und mit der Kunststoffummantelung (7) ein Gehäuse bildet und wenigstens eine Hinterschneidung (B) vorhanden ist, die in die Kunststoffummantelung (7) ragt, **dadurch gekennzeichnet, dass** ein Spalt (A), (A') zwischen der Hülse (2) der Kunststoffummantelung (7) und dem Sockel (1) vorhanden ist und der Spalt (A), (A') eine Breite (b) aufweist, die in einem Bereich von 0.5 mm liegt, dass die Höhe (a) mindestens 0,5 bis 0,8 Millimeter beträgt und dass das Gehäuse Fasen bzw. Einführschrägen (C), (D) aufweist, die ein beidseitiges Einpressen der Diode in einen Gleichrichter ermöglichen.

2. Einpressdiode nach Anspruch 1, **dadurch gekennzeichnet, dass** das Gehäuse bzw. der Sockel (1) aus einem guten elektrischen und/oder gut Wärme leitenden Material ist.

3. Einpressdiode nach einem der vorhergehenden Ansprüche, **dadurch gekennzeichnet, dass** die Kunststoffummantelung (7) zwischen dem Gehäuse und dem Chip (3) aus wenigstens der Hülse (2) und einem mit Vergussmasse ausgefüllten Bereich besteht.

4. Einpressdiode nach einem der vorhergehenden Ansprüche, **dadurch gekennzeichnet, dass** der Sockel (1) einen Rand (10) bildet, mit einem ersten Innendurchmesser und im Bereich des Grabens (A) einen verringerten Innendurchmesser aufweist.

5. Einpressdiode nach einem der vorhergehenden Ansprüche, **dadurch gekennzeichnet, dass** sie in ihrem Sockel (1) eine Kerbe (F) aufweist, die bei der Herstellung der Einpressdiode ein sicheres Fixieren ermöglicht.

## Claims

1. Press-fit diode with a chip (3), which is connected to a top wire (4) and a base (1) by means of soldered layers (5a, 5b), the base (1) having in the region of the chip (3) a platform (8), which is surrounded by a trench (9), and the platform (8) rising up from the trench (9) by a height (a), with a plastic sheathing (7), which comprises a sleeve (2) and is present at least in the region of the chip (3), and forms a mechanical connection, the base (1) at least partially enclosing the plastic sheathing (7) and forming a housing with the plastic sheathing (7), and there being at least one undercut (B), which protrudes into the plastic sheathing (7), **characterized in that** there is a gap (A), (A') between the sleeve (2) of the plastic sheathing (7) and the base (1) and the gap (A), (A') has a width (B) that lies in a range of 0.5 mm, **in that** the height (a) is at least 0.5 to 0.8 millimetres and **in that** the housing has bevels or lead-in slopes (C), (D), that allow the diode to be pressed on both sides into a rectifier.

2. Press-fit diode according to Claim 1, **characterized in that** the housing or the base (1) is made of a good electrically conducting material and/or a good thermally conducting material.

3. Press-fit diode according to one of the preceding claims, **characterized in that** the plastic sheathing (7) between the housing and the chip (3) consists of at least one sleeve (2) and a region that is filled with setting compound.

4. Press-fit diode according to one of the preceding claims, **characterized in that** the base (1) forms a border (10), with a first inside diameter, and has a reduced inside diameter in the region of the trench (A).

5. Press-fit diode according to one of the preceding claims, **characterized in that** in its base (1) it has a notch (F), which allows secure fixing during the production of the press-fit diode.

## Revendications

1. Diode sertissable dotée d'une puce (3) reliée par des couches de brasure (5a, 5b) à un fil de tête (4) et à un socle (1),
le socle (1) présentant au niveau de la puce (3) un pied (8) entouré par un sillon (9),
le pied (8) débordant du sillon (9) d'une hauteur (a),
la diode sertissable présentant une enveloppe (7) en matière synthétique qui présente une douille (2), prévue au moins au niveau de la puce (3) et formant une liaison mécanique,
le socle (1) entourant au moins une partie de l'enveloppe (7) en matière synthétique et formant avec l'enveloppe (7) en matière synthétique un boîtier,
au moins une contre-dépouille (B) qui s'enfonce dans l'enveloppe (7) en matière synthétique étant prévue,
**caractérisée en ce**
**qu'**un interstice (A), (A') entre la douille (2) de l'enveloppe (7) en matière synthétique et le socle (1) est prévu,
en ce que l'interstice (A), (A') présente une largeur (b) de l'ordre de 0,5 mm,
en ce que la hauteur (a) est d'au moins 0,5 à 0,8 millimètre et
en ce que le boîtier présente des chanfreins ou des pentes d'insertion (C), (D) qui permettent d'enfoncer la diode par les deux côtés dans un redresseur.

2. Diode sertissable selon la revendication 1, **caractérisée en ce que** le boîtier ou le socle (1) est réalisé en un matériau bon conducteur de l'électricité et/ou bon conducteur de la chaleur.

3. Diode sertissable selon l'une des revendications précédentes, **caractérisée en ce qu'**entre le boîtier et la puce (3), l'enveloppe (7) en matière synthétique est constituée d'au moins la douille (2) et d'une partie remplie d'une pâte de sertissage.

4. Diode sertissable selon l'une des revendications précédentes, **caractérisée en ce que** le socle (1) forme un bord (10) qui présente un premier diamètre intérieur et un diamètre intérieur réduit au niveau du sillon (A).

5. Diode sertissable selon l'une des revendications précédentes, **caractérisée en ce qu'**elle présente dans son socle (1) une entaille (F) qui permet une fixation sûre lors de la fabrication de la diode sertissable.
